# EUROPEAN PATENT APPLICATION

(11) **EP 1 178 714 A2**
(43) Date of publication of application: **06.02.2002**
(21) Application number: 01116441.5
(22) Date of filing: 06.07.2001
(51) Int. Cl.: H05K 3/46

(54) **Multilayer board and method for making the same**

(30) Priority: 21.07.2000 JP 2000220185
(71) Applicant: Murata Manufacturing Co., Ltd., Nagaokakyo-shi Kyoto-fu 617-8555 (JP)
(72) Inventor: Kawakami, Hiromichi, A170 Intellectual Prop. Dept., Nagaokakyo-shi, Kyoto-fu 617-8555 (JP); Niwa, Yoshihito, A170 Intellectual Prop. Dept., Nagaokakyo-shi, Kyoto-fu 617-8555 (JP)
(74) Representative: Zinnecker, Armin, Dipl.-Ing.

(57) **Abstract**

A multilayer board (2) includes a laminate of glass-containing insulating layers (9), each provided with an electrode (4) on the surface thereof. Each of the glass-containing insulating layers (9) comprises crystallizable glass. The viscosity of the crystallizable glass before crystallization is 10^{6.0} Pa·s or less. This multilayer board (2) is produced as follows. A plurality of green sheets comprising crystallizable glass having a viscosity before crystallization of 10^{6.0} or less is prepared. An electrode paste for forming an electrode (4) is applied on a surface of each of the green sheets. The green sheets with the electrode paste are laminated and compacted to form a laminate compact. Finally, the laminate compact is fired.

## Description

### BACKGROUND OF THE INVENTION

### 1. Field of the Invention

The present invention relates to a multilayer board and a method for making the same. In particular, the present invention relates to a multilayer board using a glass-ceramic material which can be fired at low temperatures and a method for making the same.

### 2. Description of the Related Art

With trends towards advanced functions and reduced sizes in electronic apparatuses, more semiconductor ICs and other surface mount devices must be mounted on a circuit board. In order to meet such a requirement, various ceramic multilayer boards which are produced by laminating and firing ceramic green sheets with an electrode paste which is applied thereon for forming electrodes have been developed and widely used in practice.

In recent years, multilayer boards using glass or glass-containing material such as glass-ceramic material which can be fired at low temperatures have been developed and widely used. Since these multilayer boards contain glass materials having insufficient mechanical strength as the primary component, crystallizable glass is used as the glass component or a substantial amount of a ceramic material is added to improve the mechanical strength.

An Ag electrode paste or the like is widely used for forming electrodes in the production of multilayer boards. When an Ag paste composed of powdered Ag or a mixture of powdered Ag and an oxide serving as a chemical bond is applied onto a board using crystallizable glass which may contain a high proportion of ceramic material, and these are simultaneously fired in order to obtain a high-strength board, there is insufficient wetting by the Ag conductor because of an increase in glass viscosity due to crystallization, resulting in insufficient bonding strength of the electrodes to the board.

A possible method for achieving sufficient bonding strength of the electrode is addition of a glass component which improves the wettability to the board of the Ag paste. In this case, however, the glass component segregates to the surface of the electrode, deteriorating the solderability of the electrode.

### SUMMARY OF THE INVENTION

The present invention provides a multilayer board which includes electrodes with high bonding strength to glass-containing insulating layers and which exhibits satisfactory solderability and a method for making the same.

According to a first aspect of the present invention, a multilayer board comprises a laminate of glass-containing insulating layers, each provided with an electrode on the surface thereof, wherein each of the glass-containing insulating layers comprises crystallizable glass, and the viscosity of the crystallizable glass before crystallization is 10^{6.0} Pa·s or less.

Since the glass-containing insulating layer of the multilayer board of the present invention contains the crystallizable glass having a viscosity before crystallization of 10^{6.0} Pa·s or less, a significant increase in viscosity of the crystallizable glass due to crystallization during firing can be suppressed and sufficient wettability between the electrodes and the glass-containing insulating layers can be ensured.

Thus, the bonding strength between the electrode and the glass-containing insulating layer is improved. Moreover, the electrode does not contain a large amount of glass component; hence, a decrease in solderability due to segregation of the glass component is prevented.

The present invention is applicable to cases in which the glass-containing insulating layer is substantially composed of crystallizable glass, composed of a material containing crystallizable glass and ceramic, or composed of a material containing crystallizable glass, amorphous glass, and ceramic. When practical levels of electrical and mechanical properties are required, a material containing crystallizable glass and ceramic is preferably used as a material constituting the glass-containing insulating layer.

Preferably, the glass-containing insulating layer further comprises ceramic, the proportion of the crystallizable glass in the glass-containing insulating layers is in the range of 45 to 80 volume percent, the viscosity of the crystallizable glass before crystallization is 10^{6.0} Pa·s or less, and the glass-containing insulating layer and the electrode formed on the surface thereof are simultaneously fired.

By such a configuration, an increase in glass viscosity due to crystallization is suppressed and the bonding strength of the electrode to the glass-containing insulating layer is improved. Moreover, the electrode does not contain a large amount of glass component; hence, solderability of the electrode is satisfactorily maintained.

Preferably, the crystallizable glass before crystallization has a viscosity in the range of 10^{5.0} Pa·s to 10^{6.0} Pa·s. The use of such crystallizable glass can reliably suppress an increase in glass viscosity due to crystallization.

Preferably, the crystallizable glass has a crystallization temperature in the range of 800°C to 900°C. By using such crystallizable glass, an increase in viscosity of the crystallizable glass due to crystallization is reliably suppressed during firing at a relatively low firing temperature in the range of approximately 800 to 1,100°C, improving bonding strength of the electrode to the glass-containing insulating layer without deterioration of solderability of the electrode.

Preferably, the initial bonding strength of the electrode to the glass-containing insulating layer in tensile strength testing is 5 N/mm² or more on average.

Preferably, the electrode comprises Ag as the primary conductive component.

Although the electrode may comprise any material in the present invention, an electrode material having high bonding strength and low resistance comprises Ag as the primary conductive component. A multilayer board having such configuration is suitable for high-frequency applications.

According to a second aspect, in a method for making a multilayer board comprising a laminate of glass-containing insulating layers, each provided with an electrode on the surface thereof, the method comprises the steps of preparing a plurality of green sheets comprising crystallizable glass having a viscosity before crystallization of 10^{6.0} Pa·s or less, applying an electrode paste for forming an electrode on a surface of each of the green sheets, laminating and compacting the green sheets with the electrode paste to form a laminate compact, and firing the laminate compact.

This method enables production of a multilayer board provided with electrodes having high bonding strength to the glass-containing insulating layer and sufficient solderability.

Preferably, the green sheets further comprises ceramic, the proportion of the crystallizable glass in the green sheet is in the range of 45 to 80 volume percent, and the crystallizable glass before crystallization has a viscosity of 10^{6.0} Pa·s or less.

By using such a green sheet, an increase in viscosity of crystallizable glass due to crystallization is suppressed and wettability between the electrode and the glass-containing insulating layer is improved. Thus, the resulting multilayer board provided with electrodes exhibits superior bonding strength to the glass-containing insulating layer and sufficient solderability.

Preferably, the crystallizable glass has a viscosity before crystallization in the range of 10^{5.0} Pa·s to 10^{6.0} Pa·s. The use of such crystallizable glass can reliably suppress an increase in glass viscosity of the crystallizable glass due to crystallization and the resulting multilayer board provided with electrodes exhibits high bonding strength to the glass-containing insulating layer and sufficient solderability.

Preferably, the green sheet further comprises ceramic, and the crystallizable glass has a crystallization temperature in the range of 800°C to 900°C. The use of such green sheet can reliably suppress an increase in glass viscosity of the crystallizable glass due to crystallization and the resulting multilayer board provided with electrodes exhibits high bonding strength to the glass-containing insulating layer and sufficient solderability.

Preferably, the electrode paste comprises Ag as the primary conductive component. Although the electrode may comprise any material in the present invention, an electrode material having high bonding strength and low resistance comprises Ag as the primary conductive component. A multilayer board having such configuration is suitable for high-frequency applications.

Preferably, the electrode paste does not contain glass. With electrode paste not containing glass, electrodes having low resistance and superior bonding strength and solderability can be formed, enhancing the advantages of the present invention.

Preferably, the electrode paste further comprises at least one material selected from the group consisting of Pb, Bi, Cr, Cu, Mn, Co, and Zn. The use of such an electrode paste further improves bonding strength of the electrodes.

Preferably, a constraining layer comprising an inorganic material which is not sintered at a firing temperature for the laminate compact is laminated on at least one face of the laminate compact before the step of firing the laminate compact, and the constraining layer is removed after the firing step (thereby providing a so-called nonshrinkage process).

In the method of the present invention, a nonshrinkage process may be employed. That is, which firing the laminate compact, a constraining layer comprising an inorganic material which is not sintered at a firing temperature for the laminate compact is laminated on one or two faces of the laminate compact, and the constraining layer is removed after firing.

This nonshrinkage process in the firing of the laminate compact can produce a multilayer board which does not exhibit shrinkage in the planar direction, but exhibits high electrode bonding strength and superior solderability. The use of the resulting multilayer board enables efficient production of electronic components, such as hybrid ICs, in which surface mounted components are mounted at precisely predetermined positions.

Other features and advantages of the present invention will become apparent from the following description of embodiments of the invention which refers to the accompanying drawings.

### BRIEF DESCRIPTION OF THE DRAWINGS

Fig. 1 is a cross-sectional view of the main part of a multilayer module using a multilayer board in accordance with an embodiment of the present invention;
Fig. 2 is a cross-sectional view of the main part of a multilayer board in accordance with an embodiment of the present invention; and
Fig. 3 is a planar view of an electrode land pattern used for evaluating the electrode bonding strength.

### DETAILED DESCRIPTION OF EMBODIMENTS OF THE INVENTION

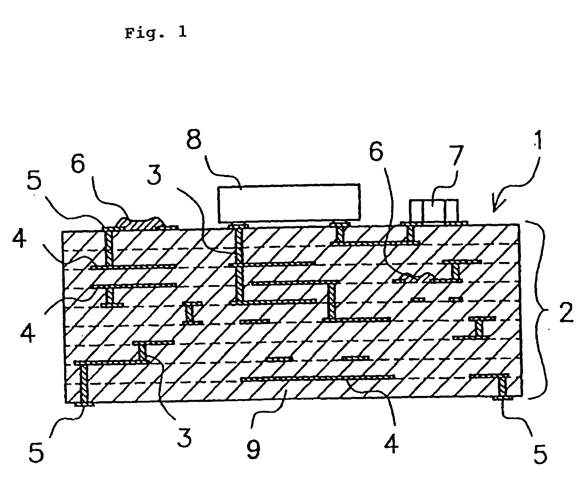

Embodiments of the present invention will now be described with reference to a board shown in Fig. 1.

A multilayer board 2 shown in Fig. 1 is used for a multilayer module 1. Thick-film resistors 6, a chip capacitor 7, and a semiconductor device 8 are mounted on the top face of the multilayer board 2. This multilayer board 2 has a laminate structure including glass-containing insulating layers 9 and internal electrodes 4, and the internal electrodes 4 on these layers are electrically connected by via holes 3 provided in the glass-containing insulating layers 9.

The internal electrodes 4 function as electrodes of passive devices, such as inductors and capacitors, or as leads for electrically connecting the passive devices, the ground, and the thick-film resistors 6.

Furthermore, surface electrodes 5 are formed on the top and bottom faces of the multilayer board 2. On the top face, the surface electrodes 5 function as lands for connecting surface mounted components, such as the chip capacitor 7 and the semiconductor device 8, to the multilayer board 2, or as leads for connecting the thick-film resistor 6 to other devices. On the bottom face, the surface electrodes 5 function as I/O terminals for connecting the multilayer board 2 to a mother board, etc.

A method for making the multilayer board shown in Fig. 1 will now be described.

### [Preparation of Green Sheets for Multilayer boards]

Preparation of green sheets used in the manufacturing of the multilayer board will now be described.
(1) Crystallizable glass powders 1 to 4 are prepared according to the compositions, viscosities before crystallization, and crystallization temperatures shown in Table 1. The crystallizable glass powders 1 to 3 are SiO₂-CaO-Al₂O₃-B₂O₃-based glass powders which contain the same components, but have different proportions or compositions so as to have different viscosities before crystallization and different crystallization temperatures.

**Table 1**

| No. | Glass Composition | Viscosity before Crystallization (Pa·s) | Crystallization Temperature (°C) |
|---|---|---|---|
| 1 | SiO₂-CaO-Al₂O₃-B₂O₃ | 10^{5.5} | 840 |
| 2 | SiO₂-CaO-Al₂O₃-B₂O₃ | 10^{6.0} | 875 |
| 3 | SiO₂-CaO-Al₂O₃-B₂O₃ | 10^{6.2} | 890 |
| 4 | SiO₂-MgO-Al₂O₃-B₂O₃ | 10^{5.0} | 800 |

In Table 1, the viscosity before crystallization and the crystallization temperature of each glass powder are measured using a parallel plate pressured viscometer. The "viscosity before crystallization" indicates the minimum viscosity before crystallization and the "crystallization temperature" indicates the temperature when the minimum viscosity before crystallization is obtained. The measurement is performed according to "Viscosimetry of Powdered Glass by a Parallel Plate Method" reported in the 40th Glass and Photonics Symposium (The Ceramic Society of Japan).
(2) Next, crystallizable glass powders 1 to 4 shown in Table 1 and alumina (Al₂O₃) powder are mixed according to formulations shown in Table 2.

**Table 2**

| Sample | Glass Powder Content (volume %) | Alumina Powder Content (volume %) | Glass Type | Solderability | Electrode Bonding Strength |
|---|---|---|---|---|---|
| 1 | 80 | 20 | 1 | Good | Good |
| 2 | 80 | 20 | 2 | Good | Good |
| 3 | 80 | 20 | 3 | Good | Not Good |
| 4 | 80 | 20 | 4 | Good | Good |
| 5 | 60 | 40 | 1 | Good | Good |
| 6 | 60 | 40 | 2 | Good | Good |
| 7 | 60 | 40 | 3 | Good | Not Good |
| 8 | 60 | 40 | 4 | Good | Good |
| 9 | 45 | 55 | 1 | Good | Good |
| 10 | 45 | 55 | 2 | Good | Good |
| 11 | 45 | 55 | 3 | Good | Not Good |
| 12 | 45 | 55 | 4 | Good | Good |

(3) An organic binder and toluene as a solvent are added to the powder mixture (glass-ceramic powder mixture) and these are mixed thoroughly in a ball mill to prepare a uniformly dispersed slurry. The slurry is defoamed under reduced pressure.
Organic vehicles, such as a binder, a solvent, and a plasticizer, can be used in any formulation without restriction.
(4) The slurry is applied onto a film by, for example, a casting process using a doctor blade to form a green sheet with a thickness of 0.1 mm.
(5) The green sheet is dried, is detached from the film, and is cut into green sheets with predetermined dimensions for forming a multilayer board.

### [Preparation of Green Sheet for Constraining Layer]

A method for making green sheets for constraining layers which are used in a nonshrinkage process will now be described.

The green sheets for constraining layers are primarily composed of inorganic materials which are not sintered in a firing step for the green sheets for the multilayer board. These green sheets for constraining layers are laminated on two faces or one face of the laminate compact of the green sheets of the multilayer board, and are removed after the firing step.
(1) Al₂O₃ powder, an organic binder, and toluene as a solvent are thoroughly compounded in a ball mill and the mixture is defoamed under reduced pressure to prepare a uniformly dispersed slurry.
   Organic vehicles, such as a binder, a solvent, and a plasticizer, can be used in any formulation without restriction.
(2) The material slurry is applied onto a film by, for example, a casting process using a doctor blade to form a green sheet with a thickness of 0.1 mm.
(3) The green sheet is dried, is detached from the film, and is cut into green sheets with predetermined dimensions for constraining layers.

### [Preparation of Multilayer board]

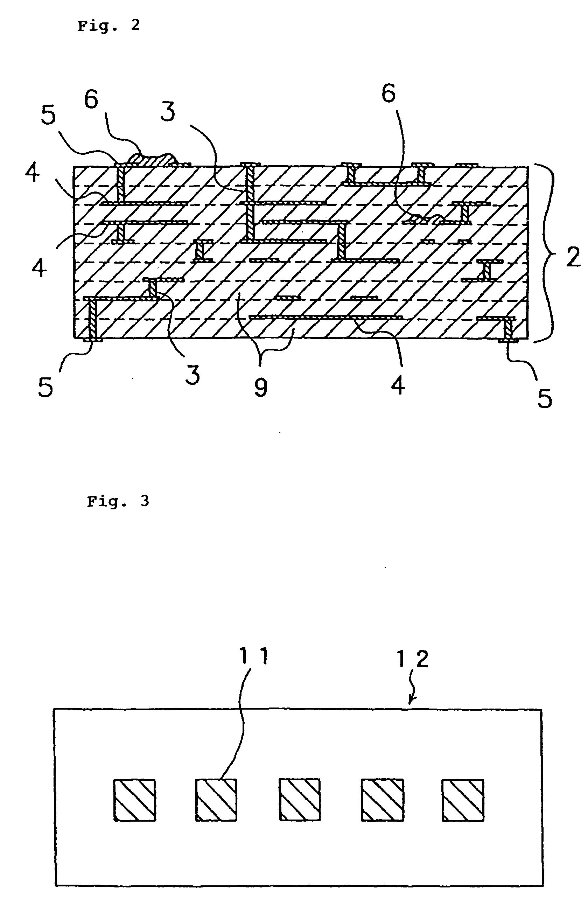

A method for making the multilayer board will now be described.
(1) Holes are formed in the green sheets for the glass-containing insulating layers and are filled with a conductive paste or conductive powder to form via holes.
(2) On each green sheet, an electrode paste for forming electrodes of passive devices, such as inductors and capacitors, and a predetermined wiring pattern is applied by a screen printing process or the like. Moreover, a resistor material paste for forming thick-film resistors is applied by a screen printing process or the like, if necessary.
   In this embodiment, the electrode paste contains Ag as a conductive component and does not contain glass. In the present invention, however, the type of the electrode paste is not limited, and any type of electrode paste containing for example Ag/Pt powder or Ag/Pd powder as a conductive component can be used.
(3) A predetermined number of the resulting green sheets are stacked to form a laminate, and a predetermined number of the above green sheets for constraining layers are laminated on the top and bottom faces of the laminate. The laminate is compacted to form the laminate compact.
(4) The laminate compact is cut into a predetermined size or dividing grooves are formed thereon, if necessary. Then, the laminate compact is fired at a temperature of 800°C to 1,100°C. The constraining layers are removed to prepare a multilayer board 2 shown in Fig. 2. In Fig. 2, the components referred to by the same reference numerals indicate the same components shown in Fig. 1.
(5) Surface mounted components, such as a chip capacitor 7 and a semiconductor device 8, are mounted onto the multilayer board 2 to prepare the multilayer module 1 shown in Fig. 1.

### [Preparation of Sample for Characteristic Evaluation]

With reference to Fig. 3, 2-mm square land electrodes 11 for measuring solderability and electrode bonding strength were formed on a green sheet 12 of the tape for use in the multilayer board. This green sheet 12 was placed on the surface layer of a plurality of underlying green sheets not having land electrodes. The laminate was compacted, and the compact was heated to 400°C at a heating rate of 1.5 °C/min and to 910°C at a heating rate of 20 °C/min, and then was maintained at 910°C for 15 min for firing. The constraining layers were removed to prepare a sample for characteristics evaluation.

The solderability and the electrode bonding strength of the resulting sample for evaluation were determined. The results are shown in Table 2.

The solderability was evaluated by dipping the 2-mm square land electrode into a molten Sn-Pb solder.

After the solderability was evaluated, an L-shaped lead wire was soldered to this 2-mm square land electrode using the Sn-Pb solder, and the electrode bonding strength was measured by tensile testing using an autograph made by Shimadzu Corporation. The electrode bonding strength was taken to be the value when this sample broke in the tensile testing.

The criteria for determining the solderability and the electrode bonding strength in Table 2 are as follows:

### (Solderability)

The solderability was evaluated as "good" when the area of the land electrode wetted by the solder was 95% or more, and as "not good" when the area was less than 95%.

### (Electrode Bonding Strength)

The electrode bonding strength was evaluated as "good" when the break strength in the tensile testing of the land electrode soldered to the L-shaped lead wire using the Sn-Pb solder was 20 N/2-mm square (5N/mm²) or more, and as "not good" when the break strength was less than 20 N/2-mm square (5N/mm²).

Table 2 demonstrates that samples 1, 2, 4 to 6, 8 to 10, and 12 exhibit satisfactory results regarding the solderability and the electrode bonding strength. Accordingly, the bonding strength between the electrode and the glass-containing insulating layer can be improved with the present invention by suppressing an increase in viscosity of the crystallizable glass due to crystallization. Moreover, the electrode does not contain a large amount of glass component; hence, the solderability of the electrode is maintained at a satisfactory level.

In contrast, samples 3, 7, and 10 in Table 2 do not exhibit satisfactory bonding strength, because these samples use a SiO₂-Ca-Al₂O₃-B₂O₃-based crystallizable glass powder of sample 3 in Table 1 having a viscosity before crystallization of 10^{6.2} Pa·s, which is higher than the upper limit 10^{6.0} Pa·s in the present invention, and a crystallization temperature of 890°C.

When the glass component content in the glass-containing insulating layer before firing exceeds 80 volume percent, the solderability tends to decrease, although not shown in Table 2. When the glass component content in the glass-containing insulating layer before firing is less than 45 volume percent, the electrode bonding strength tends to decrease.

When the crystallizable glass has a viscosity before crystallization of 10^{5.0} Pa·s or less, the solderability tends to decrease.

Accordingly, it is preferable in the present invention that the crystallizable glass content be in the range of 45 to 80 volume percent and the viscosity of the crystallizable glass before crystallization be in the range of 10^{5.0} Pa·s to 10^{6.0} Pa·s.

The present invention is not limited to the above embodiments, and can involve various applications and modifications regarding the types and compositions of materials for constituting the glass-containing insulating layer, the crystallizable glass content in the glass-containing insulating layer, the type of the conductive component constituting the electrode, and the firing conditions, within the scope of the present invention.

Although the present invention has been described in relation to particular embodiments thereof, many other variations and modifications and other uses will become apparent to those skilled in the art. Therefore, the present invention is not limited by the specific disclosure herein.

## Claims

1. A multilayer board comprising a laminate of glass-containing insulating layers, each provided with an electrode on the surface thereof, wherein
each of the glass-containing insulating layers comprises crystallizable glass, and
the viscosity of the crystallizable glass before crystallization is 10^{6.0} Pa·s or less.

2. A multilayer board according to claim 1, wherein the glass-containing insulating layers further comprise ceramic, the proportion of the crystallizable glass in the glass-containing insulating layers is in the range of 45 to 80 volume percent, the viscosity of the crystallizable glass before crystallization is 10^{6.0} Pa·s or less, and the glass-containing insulating layer and the electrode formed on the surface thereof are cofired.

3. A multilayer board according to claim 1, wherein the crystallizable glass before crystallization has a viscosity in the range of 10^{5.0} Pa·s to 10^{6.0} Pa·s.

4. A multilayer board according to claim 1, wherein the crystallizable glass has a crystallization temperature in the range of 800°C to 900°C.

5. A multilayer board according to claim 1, wherein the average bonding strength of the electrode to the glass-containing insulating layer is 5 N/mm² or more.

6. A multilayer board according to any one of claims 1 to 5, wherein the electrode comprises Ag as the primary conductive component.

7. A method for making a multilayer board comprising a laminate of glass-containing insulating layers, each provided with an electrode on the surface thereof, the method comprising the steps of:
preparing a plurality of green sheets comprising crystallizable glass having a viscosity before crystallization of 10^{6.0} or less;
applying an electrode paste for forming an electrode on a surface of each of the green sheets;
laminating and compacting the green sheets with the electrode paste to form a laminate compact; and
firing the laminate compact.

8. A method for making a multilayer board according to claim 7, wherein the green sheets further comprises ceramic, the proportion of the crystallizable glass in the green sheet is in the range of 45 to 80 volume percent, and the crystallizable glass before crystallization has a viscosity of 10^{6.0} Pa·s or less.

9. A method for making a multilayer board according to claim 7, wherein the crystallizable glass has a viscosity before crystallization in the range of 10^{5.0} Pa·s to 10^{6.0} Pa·s.

10. A method for making a multilayer board according to claim 7, wherein the green sheet further comprises ceramic, and the crystallizable glass has a crystallization temperature in the range of 800°C to 900°C.

11. A method for making a multilayer board according to claim 7, wherein the electrode paste comprises Ag as the primary conductive component.

12. A method for making a multilayer board according to claim 11, wherein the electrode paste contains substantially no glass.

13. A method for making a multilayer board according to claim 11, wherein the electrode paste further comprises at least one material selected from the group consisting of Pb, Bi, Cr, Cu, Mn, Co, and Zn.

14. A method for making a multilayer board according to claim 7, wherein a constraining layer comprising an inorganic material which is not sintered at a firing temperature for the laminate compact is laminated on at least one face of the laminate compact before the firing step of the laminate compact, and the constraining layer is removed after the firing step.
